# EUROPEAN PATENT SPECIFICATION

(11) **EP 2 732 970 B1**
(45) Date of publication and mention of the grant of the patent: **24.06.2015**
(21) Application number: 13189809.0
(22) Date of filing: 23.10.2013
(51) Int. Cl.: B32B 25/14, B32B 17/10, B32B 27/32, H01L 31/048

(54) **Module structure**
Modulstruktur
Structure de module

(30) Priority: 20.11.2012 TW 101143193; 26.06.2013 TW 102122642
(43) Date of publication of application: 21.05.2014
(73) Proprietor: Industrial Technology Research Institute, Chutung Hsinchu 31040 (TW)
(72) Inventor: Wang, Wen-Hsien, 722 Tainan City (TW); Kuan, Min-Tsung, 436 Taichung City (TW); Lee, Tzong-Ming, 300 Hsinchu City (TW); Chou, Wen-Hsien, 637 Yunlin County (TW); Lin, Fu-Ming, 310 Hsinchu County (TW); Lee, Wen-Kuei, 516 Changhua County (TW); Yeh, Chin Zeng, 807 Kaohsiung City (TW); Chen, Ming-Hung, 807 Kaohsiung City (TW); Huang, Chung-Teng, 422 Taichung City (TW); Fu, Hsueh Jen, 830 Kaohsiung City (TW)
(74) Representative: Fuchs Patentanwälte Partnerschaft mbB

(56) References cited:
- WO-A1-2012/051930
- JP-A- 2012 107 107
- US-A1- 2006 166 023
- US-A1- 2010 000 603

## Description

### CROSS REFERENCE TO RELATED APPLICATIONS

This Application claims priority of Taiwan Patent Application No. 101143193, filed on November 20, 2012, and Taiwan Patent Application No. 102122642, filed on June 26, 2013.

### TECHNICAL FIELD

The technical field relates to a module structure, and in particular to the back sheet thereof.

### BACKGROUND

A general module structure in a solar cell includes a glass front sheet, an ethylene-vinylene acetate (EVA) copolymer encapsulate film, a solar cell, another EVA copolymer encapsulate film, and a back sheet from top to bottom. The EVA copolymer encapsulate films may fasten to the solar cell, connect to circuit lines, insulate and protect the solar cell, and maintain solar cell performance after long-term use. The back sheet may provide electrical insulation, thermal resistance, and moisture resistance to expand the lifetime of the module structure of the solar cell.

Existing back sheets are composed of fluorinated resin films and polyethylene terephthalate (PET) film. The fluorinated resin films are usually coated or laminated on two sides of the PET film to meet the requirements of moisture resistance and the like. In addition, the adhesive coating layer is utilized to provide sufficient adhesion between the fluorinated resin film and the EVA copolymer encapsulate film.

Accordingly, developing a novel back sheet structure is called for.

### SUMMARY

One embodiment of the disclosure provides a module structure, comprising: a front sheet; a back sheet opposite to the front sheet; an optoelectronic device disposed between the front sheet and the back sheet; and a first encapsulation layer disposed between the optoelectronic device and the front sheet, wherein the back sheet is a layered structure of a hydrogenated styrene elastomer resin layer and a polyolefin layer, and the hydrogenated styrene elastomer resin layer is disposed between the optoelectronic device and the polyolefin layer.

A detailed description is given in the following embodiments with reference to the accompanying drawings.

### BRIEF DESCRIPTION OF THE DRAWINGS

The disclosure can be more fully understood by reading the subsequent detailed description and examples with references made to the accompanying drawings, wherein:
Fig. 1 is a module structure in one embodiment of the disclosure; and
Fig. 2 is a module structure in another embodiment of the disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are shown schematically in order to simplify the drawing.

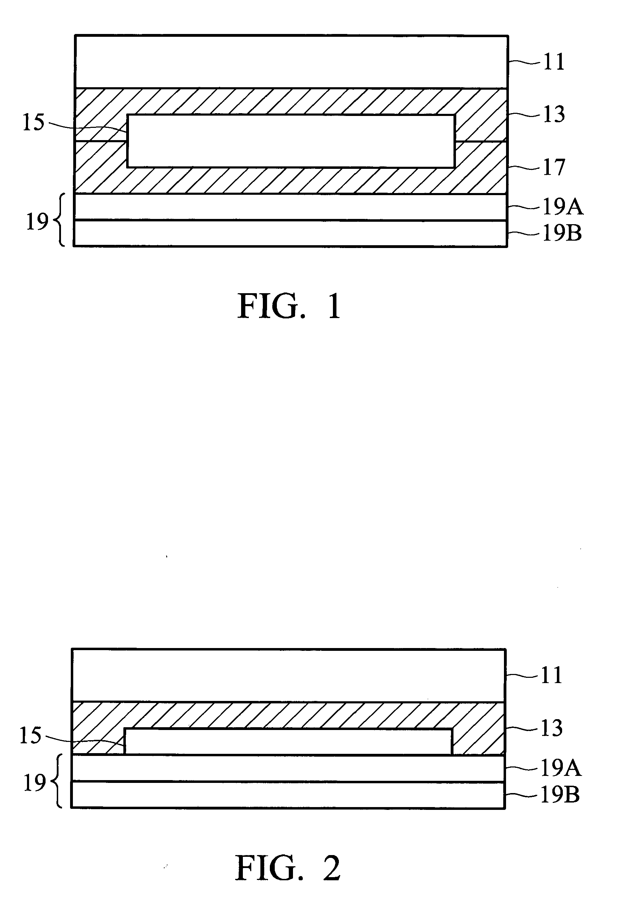

Fig. 1 is a module structure in one embodiment of the disclosure. From top to bottom, the module structure includes a front sheet 11, an encapsulation layer 13, an optoelectronic device 15, an encapsulation layer 17, and a back sheet 19. The front sheet 11 can be glass, ethylene tetrafluoroethylene (ETFE), polyacrylate, or another transparent material. In one embodiment, the encapsulation layers 13 and 17 can be made of EVA copolymer. As shown in Fig. 1, the back sheet 19 is a two-layered structure of a hydrogenated styrene elastomer resin layer 19A and a polyolefin layer 19B, wherein the hydrogenated styrene elastomer resin layer 19A is disposed between the encapsulation layer 17 and the polyolefin layer 19B. Compared to the PET film in some back sheet, the polyolefin layer 19B has lower moisture absorption, higher hydrolysis resistance, higher electrical insulation, and higher climate resistance. The hydrogenated styrene elastomer resin layer 19A may serve as an adhesive layer between the polyolefin layer 19B and the encapsulation layer 17. In one embodiment, an additional protective film (e.g. fluorinated resin film) attached thereon may be omitted from the polyolefin layer 19B. In addition, the polyolefin layer 19B and the hydrogenated styrene elastomer resin layer 19A can be coextruded to form a bi-layered structure for reducing steps and manufacturing periods in the process.

In one embodiment, the optoelectronic device 15 is a solar cell. Alternatively, the optoelectronic device 15 can be, but is not limited to, a light-emitting diode (LED), an organic light-emitting diode (OLED) or a liquid-crystal display (LCD).

In one embodiment, the hydrogenated styrene elastomer resin layer 19A can be hydrogenated poly(styrene-b-isoprene), hydrogenated poly(styrene-b-isoprene-b-styrene, hydrogenated poly(styrene-b-butadiene-b-styrene), hydrogenated poly(styrene-b-isoprene/butadiene-b-styrene, or hydrogenated poly(styrene-b-vinyl bonded rich polyisoprene). The hydrogenated styrene elastomer resin layer 19A contains 10wt% to 35wt% of a polystyrene block. In one embodiment, the hydrogenated styrene elastomer resin layer 19A contains 13wt% to 30wt% of a polystyrene block. An overly low polystyrene block ratio may degrade the hardness and the mechanical tensile strength of the copolymer. An overly high polystyrene block ratio may improve the hardness and the mechanical tensile strength of the copolymer, however the flowability and the related processibility of the copolymer is lowered, and the glass transfer temperature (Tg) of the copolymer is increased to reduce the adhesive properties of the copolymer. The molecular weight and melt index of the hydrogenated styrene elastomer resin layer 19A have a negative correlation. In short, a higher melt index means a lower molecular weight. For example, the hydrogenated styrene elastomer resin layer 19A with a lower melt index has a higher molecular weight. In one embodiment, the hydrogenated styrene elastomer resin layer 19A has a melt index of about 1.0 g/10min to 8 g/10min, or of about 3.5 g/10min to 6.5 g/10min. The hydrogenated styrene elastomer resin layer 19A with an overly low melt index may have flowability which is too low to form a film with a uniform thickness. The hydrogenated styrene elastomer resin layer 19A with an overly high melt index may have flowability which is too high for separation from other films, and it may mix with the other films.

The polyolefin layer 19B can be polyethylene, polypropylene, ethylenepropylene copolymer, a combination thereof, or multi-layered structures thereof. The molecular weight and melt index of the polyolefin layer 19B have a negative correlation. In short, a higher melt index means a lower molecular weight. For example, the polyolefin layer 19B with a lower melt index has a higher molecular weight. In one embodiment, the polyolefin layer 19B has a melt index of about 1.0 g/10min to 8 g/10min. The polyolefin layer 19B with an overly low melt index may have flowability which is too low to form a film with a uniform thickness. The polyolefin layer 19B with an overly high melt index may have flowability which is too high for separation from other films, and it may mix with the other films.

In one embodiment, the hydrogenated styrene elastomer resin layer 19A has a thickness of 50µm to 150µm.

In one embodiment, the polyolefin layer 19B has a thickness of 200µm to 500µm. An overly thick polyolefin layer 19B will increase the cost, weight, and thickness of the product. An overly thin polyolefin layer 19B cannot efficiently protect the optoelectronic device 15.

In one embodiment, a reflectivity modifier, a pigment, an anti-oxidant, or a combination thereof can be further added into the hydrogenated styrene elastomer resin layer 19A and/or the polyolefin layer 19B of the back sheet 19. The reflectivity modifier such as metal oxide (e.g. titanium oxide, magnesium oxide, clay, or a combination thereof), calcium carbonate, silicon oxide, or a combination thereof may enhance the reflectivity of the module structure, thereby further increasing the conversion efficiency of the solar cell (optoelectronic device 15). A pigment such as carbon black or pigment masterbatch (e.g. Clariant REMAFIN, polyolefin masterbatch) may change the color appearance of the module structure to match the building style. An anti-oxidant such as dibutyl hydroxyl toluene (BHT), bis(2,2,6,6-tetramethyl-4-piperidyl)sebacate, benzophenonone, a derivative thereof, or a combination thereof may prevent the yellowness of the hydrogenated styrene elastomer resin layer 19A and/or the polyolefin layer 19B. In general, the additives and the hydrogenated styrene elastomer resin layer 19A (or the polyolefin layer 19B) have a weight ratio of less than about 10:100, or of about 0.1:100 to 10:100, or of about 5:100 to 10:100. An overly high amount of the additives will destroy the processibility of the hydrogenated styrene elastomer resin layer 19A (or the polyolefin layer 19B).

In another embodiment, the thickness of the hydrogenated styrene elastomer resin layer 19A can be further increased to omit the encapsulation layer 17, as shown in Fig. 2. For example, the thickness of the hydrogenated styrene elastomer resin layer 19A can be increased to 150µm to 300µm. The thicker hydrogenated styrene elastomer resin layer 19A may enhance the impact resistance of the module structure to protect the optotronic device 15. The bottom electrode of conventional optoelectronic devices usually has a low acid resistance (e.g. aluminum), and the encapsulation layer 17 such as EVA will release acetic acid after use for a long period due to high temperature and moisture, such that the acetic acid from the encapsulation layer may destroy the bottom electrode of the optoelectronic device 15 and reduce its lifetime. In the embodiment omitting the encapsulation layer 17, the optoelectronic device is in direct contact with the hydrogenated styrene elastomer resin layer 19A of the back sheet 19 to avoid the problem described above.

The encapsulation layer 17 in Fig. 1 has impact resistance, such that the polyolefin layer 19B of the back sheet 19 can be arbitrarily selected without considering its impact resistance. The encapsulation layer 17 is omitted in the module structure in Fig. 2, such that the polyolefin layer 19B of the back sheet 19 is selected to consider its impact resistance. For example, the polyolefin layer 19B should have an impact resistance greater than about 10kg-cm/cm, e.g. a polypropylene K8002 commercially available from Formosa Chemicals & Fiber Corp.

Below, exemplary embodiments will be described in detail with reference to accompanying drawings so as to be easily realized by a person having ordinary knowledge of the art. The inventive concept may be embodied in various forms without being limited to the exemplary embodiments set forth herein. Descriptions of well-known parts are omitted for clarity, and like reference numerals refer to like elements throughout.

### EXAMPLES

### Example 1

100kg of hydrogenated styrene elastomer resin (LS611 commercially available from Asahi Chemical Co. Ltd., melt index of 5.4 g/10min) and 9kg of titanium oxide (R706 commercially available from Dupont) were blended and pelletized by a twin-screw blender.

100kg of a polypropylene (K8002 commercially available from Formosa Chemicals & Fiber Corp., melt index of 1.2 g/10min) and 9kg of titanium oxide (R706 commercially available from Dupont) were blended and pelletized by a twin-screw blender.

The blended hydrogenated styrene elastomer resin/titanium oxide pellets and the blended polypropylene/titanium oxide pellets were put into different feed ports of a tri-axial extruder to be extruded to form a back sheet. The back sheet is a layered structure of a hydrogenated styrene elastomer resin/titanium oxide film attached onto a polypropylene/titanium oxide film. The physical properties of the back sheet are tabulated in Table 1.

### Example 2

Example 2 is similar to Example 1, and the difference in Example 2 is that the polypropylene K8002 was replaced by polypropylene K8009 (commercially available from Formosa Chemicals & Fiber Corp., melt index of 7.5 g/10min). The other compositions and manufacturing processes of the back sheet were similar to those in Example 1. The physical properties of the back sheet are tabulated in Table 1.

### Example 3

Example 3 is similar to Example 1, and the difference in Example 3 is that the polypropylene K8002 was replaced with polypropylene YUNGSOX. 2100M (commercially available from Formosa plastics Co., melt index of 7.5 g/10min). The other compositions and manufacturing processes of the back sheet were similar to those in Example 1. The physical properties of the back sheet are tabulated in Table 1.

### Comparative Example 1

The physical properties of a commercially available back sheet (Protekt HD commercially available from Medico, tetra-layered structure of 13µm Protekt coating/127µm PET/adhesive/100µm EVA) are tabulated in Table 1.

### Comparative Example 2

The physical properties of a commercially available back sheet (Icosolar AAA 3554 commercially available from Isovota Co,, tri-layered structure of polyamide/polyamide/polyamide) are tabulated in Table 1.

### Comparative Example 3

The physical properties of a commercially available back sheet (Icosolar APA 3552 commercially available from Isovota Co., tri-layered structure of polyamide/PET/polyamide) are tabulated in Table 1.

**Table 1**

| | Comparative Example 1 | Comparative Example 2 | Comparative Example 3 | Example 1 | Example 2 | Example 3 |
|---|---|---|---|---|---|---|
| Thickness (mm) | 0.27 | 0.395 | 0.365 | 0.408 | 0.497 | 0.476 |
| Breaking voltage⁵ (kV) | 12 | 12.5 | 12.4 | 16.7 | 17.4 | 17 |
| Water permeability rate² (g/m²·day) | 1.6 | 1.3 | 0.8 | 0.4 | 0.2 | 0.2 |
| Volume Resistivity¹ (Ω · cm) | 7.38E+15 | 6.88E+12 | 1.85E+15 | 7.89E+15 | 5.9E+15 | 8.45E+16 |
| Elongation at break³ (%) | 26 | 185 | 60 | 417 | 423 | 427 |
| Peeling force to an EVA layer at room temperature (about 25°C)⁴ (average load, N/cm) | 59.62 | 41.2 | 52.57 | 65.58 | 65.61 | 75.81 |
| Peeling force to an EVA layer after water boiled at 90°C for 48 hours⁴ (average load, N/cm) | 38.66 | 2.2 | 26.35 | 65.19 | 64.13 | 76.92 |
| Peeling force to an EVA layer after frozen at 6 °C for 24 hours⁴ (average load, N/cm) | 54.04 | 36.9 | 57.17 | 63.68 | 69.33 | 76.69 |
| Thickness of PP/hydrogenated styrene 6 elastomer resin⁶ (µm/µm) | none | none | none | 325/83 | 406/91 | 392/84 |

| | | | | | | |
|---|---|---|---|---|---|---|
| Note: 1. Measured with the standard ASTM D257-07 by the equipment HIOKI SM-8220 and HIOKI SME-8311. 2. Measured with the standard ASTM F1249-06 by the equipment Mocon 3/60. 3. Measured with the standard ASTM 1876-01 by universal testing machine. 4. Measured with the standard ASTM D-1876-BS-EVA-BS by universal testing machine. 5. Measured with the standard ASTM D149 by the equipment Hipotronic Mode:730-1. 6. Measured by scanning electron microscopy (SEM). | | | | | | |

As shown in the comparison in Table 1, the back sheets of Examples 1 to 3 had good physical properties and higher peeling force to the EVA than the commercially available back sheets of Comparative Examples 1 to 3. For example, the back sheets of Examples 1 to 3 had breaking voltages of about 16kV to 18kV, water permeabilities of about 0.2 g/m²·day to 0.4g/m²·day, elongation at break of about 400% to 450%, peeling forces of 60N/cm to 80N/cm to an EVA layer at room temperature, peeling forces of 60N/cm to 80N/cm to an EVA layer at high temperature (about 90°C) and high humidity, and peeling forces of 60N/cm to 80N/cm to an EVA layer at room temperature after low-temperature treatment (about 6°C).

### Example 4

100kg of hydrogenated styrene elastomer resin (LS611 commercially available from Asahi chemical Co. Ltd., melt index of 5.4 g/10min) and 9kg of titanium oxide (R706 commercially available from Dupont) were blended and pelletized by a twin-screw blender.

100kg of a polypropylene (K8009, commercially available from Formosa Chemicals & Fiber Corp., melt index of 7.5 g/10min) and 9kg of titanium oxide (R706 commercially available from Dupont) were blended and pelletized by a twin-screw blender.

100kg of a polypropylene (YUNGSOX 2100, commercially available from Formosa plastics Co., melt index of 7.0 g/10min) and 9kg of titanium oxide (R706 commercially available from Dupont) were blended and pelletized by a twin-screw blender.

The blended hydrogenated styrene elastomer resin/titanium oxide pellets and the blended polypropylene/titanium oxide pellets were put into different feed ports (controlled by a feedblock) of a tri-axial extruder to be extruded to form a back sheet. The back sheet is a tri-layered structure with a thickness of about 0.400mm, wherein a hydrogenated styrene elastomer resin/titanium oxide film attached onto a polypropylene (YUNGSOX 2100)/titanium oxide film (middle layer), which is attached onto another polypropylene (K8009)/titanium oxide film. The physical properties of the back sheet are tabulated in Table 2.

### Example 5

Example 5 is similar to Example 4, and the difference in Example 5 is that the film thicknesses of the hydrogenated styrene elastomer resin/titanium oxide film, the polypropylene (YUNGSOX 2100)/titanium oxide film, and the polypropylene (K8009)/titanium oxide film were different from that of Example 4. The total thickness of the back sheet in Example 5 was about 0.500mm, and the physical properties of the back sheet are tabulated in Table 2.

**Table 2**

| | Example 1 | Example 2 | Example 3 | Example 4 | Example 5 |
|---|---|---|---|---|---|
| Total thickness (mm) | 0.408 | 0.497 | 0.476 | 0.425 | 0.581 |
| Breaking voltage⁵ (kV) | 16.7 | 17.4 | 17 | 20 | 20.9 |
| Water permeability rate² (g/m²·day) | 0.4 | 0.2 | 0.2 | 0.345 | 0.257 |
| Reflectivity⁷ (%) | 85 | 87 | 87 | 89.68 | 90.85 |
| Volume Resistivity¹ (Ω· cm) | 7.89E+15 | 5.9E+15 | 8.45E+16 | 7.66E+18 | 5.86E+18 |
| Maximum load point stress³ (MPa) | 32 | 32 | 33 | 31.3 | 30.3 |
| Elongation at break³ (%) | 417 | 423 | 427 | 327.03 | 330.27 |
| Peeling force to an EVA layer at room temperature (about 25°C)⁴ (average load, N/cm) | 65.58 | 65.61 | 75.81 | 65.97 | 68.82 |
| Peeling force to an EVA layer after water boiled at 90°C for 48 hours⁴ (average load, N/cm) | 65.19 | 64.13 | 76.92 | 65.48 | 55.36 |
| Peeling force to an EVA layer after frozen at 6 °C for 24 hours⁴ (average load, N/cm) | 63.68 | 69.33 | 76.69 | 69.08 | 69.87 |
| Thickness of PP/hydrogenated styrene elastomer resin⁶ (µm/µm) | 325/83 | 406/91 | 392/84 | 117/124/184 (241/18 4) | 233/180/168 (413/16 8) |

| | | | | | |
|---|---|---|---|---|---|
| Note: 1. Measured with the standard ASTM D257-07 by the equipment HIOKI SM-8220 and HIOKI SME-8311. 2. Measured with the standard ASTM F1249-06 by the equipment Mocon 3/60. 3. Measured with the standard ASTM 1876-01 by universal testing machine. 4. Measured with the standard ASTM D-1876-BS-EVA-BS by universal testing machine. 5. Measured with the standard ASTM D149 by the equipment Hipotronic Mode:730-1. 6. Measured by scanning electron microscopy (SEM). 7. Measured by UV-VIS spectrometer Hitachi U-3010. | | | | | |

As shown in comparisons in Table 2, the back sheets in Examples 1-5 have similar physical properties and peeling forces to the EVA layer.

An encapsulation layer (EVA with a thickness of 0.42mm, RC02B commercially available from Mitsui Chemicals Tocello Inc.), a solar cell (Monocrystalline D6 (6 inch), conversion efficiency of 18.4%, commercially available from DelSolar Co., Ltd.), another encapsulation layer (EVA with a thickness of 0.42mm, RC02B commercially available from Mitsui Chemicals Tocello Inc.), and 3.2mm×18cm×18cm of front sheet (super clear glass commercially available from Stanley glass) were sequentially stacked on the back sheets (with a thinner hydrogenated styrene elastomer resin/titanium oxide film) in Examples 1-3, respectively. The stacked structures were then vacuum packed at 150°C for 15 minutes by a laminator (LM-SA-170x260-S) to obtain the module structures shown in Fig. 1. The module structures were processed in an aging test, e.g. exposed to 15kWh/m² UV by a UV aging machine TMJ-9705WM-UV and/or water boiled at 90°C for different periods, to determine the maximum power of the solar cell before and after the aging test, as tabulated in Table 3. The module structures could be directly exposed to UV (15kWh/m²) to determine the maximum power of the solar cell before and after the aging test, as tabulated in Table 4.

A solar cell (Monocrystalline D6 (6 inch), conversion efficiency of 18.4%, commercially available from DelSolar Co., Ltd.), an encapsulation layer (EVA with a thickness of 0.42mm, RC02B commercially available from Mitsui Chemicals Tocello Inc.), and 3.2mm×18cm×18cm of front sheet (super clear glass commercially available from Stanley glass) were sequentially stacked on the back sheets (with a thicker hydrogenated styrene elastomer resin/titanium oxide film) in Example 4. The stacked structure was then vacuum packed at 150°C for 15 minutes by a laminator (LM-SA-170x260-S) to obtain the module structures shown in Fig. 2. The module structure was processed in an aging test, e.g. exposed to UV (15kWh/m²) by a UV aging machine TMJ-9705WM-UV and/or water boiled at 90°C for different periods, to determine the maximum power of the solar cell before and after the aging test, as tabulated in Table 3. The module structure was directly exposed to UV (15kWh/m²) to determine the maximum power of the solar cell before and after the aging test, as tabulated in Table 4.

**Table 3**

| | | Initial maximum power (W) | Maximum power (W) after exposing to UV and putting in boiling water for 250 hours | Maximum power (W) after putting in boiling water for 500 hours | Maximum power (W) after putting in boiling water for 750 hours | Maximum power loss ratio (%) |
|---|---|---|---|---|---|---|
| Example 1 | Module structure in Fig. 1 | 4.05 | 3.88 | 3.89 | 3.84 | 5.25 |
| Example 2 | | 4.07 | 3.95 | 3.93 | 3.89 | 4.52 |
| Example 3 | | 4.13 | 4.04 | 3.99 | 3.96 | 4.15 |
| Example 4 | Module structure in Fig. 2 | 4.01 | 3.96 | 3.96 | 3.90 | 2.68 |

**Table 4**

| | | Before UV exposure | | | | After UV exposure | | | | Max. power loss | Max. power loss ratio (%) |
|---|---|---|---|---|---|---|---|---|---|---|---|
| | | Open circuit voltage | Short circuit current | Maximum power | Fill factor | Open circuit voltage | Short circuit current | Maximu m power | Fill factor | | |
| Example 1 | Module structure in Fig. 1 | 0.63 | 8.92 | 4.06 | 72.43 | 0.62 | 8.81 | 3.99 | 72.71 | -0.07 | 1.72 |
| Example 2 | | 0.63 | 8.94 | 4.08 | 72.93 | 0.62 | 8.90 | 3.96 | 71.54 | -0.12 | 3.03 |
| Example 3 | | 0.63 | 8.94 | 4.08 | 72.73 | 0.62 | 8.87 | 3.96 | 71.73 | -0.13 | 3.10 |
| Example 4 | Module structure in Fig. 2 | 0.63 | 8.87 | 3.96 | 71.04 | 0.62 | 8.81 | 3.94 | 71.89 | -0.01 | 0.30 |

As shown by the comparisons in Tables 3 and 4, the solar cell in the module structure in Fig. 2 (omitting the encapsulation layer 17) has a lower power loss after the aging test than the solar cell in the module structure in Fig. 1. The above phenomenon may result from the bottom electrode (aluminum) of the solar cell in the module structure of Fig. 2 not being in contact with the encapsulation layer (e.g. EVA), such that the acetic acid released from the EVA will not destroy the bottom electrode of the solar cell.

It will be apparent to those skilled in the art that various modifications and variations can be made to the disclosed methods and materials. It is intended that the specification and examples be considered as exemplary only, with a true scope of the disclosure being indicated by the following claims and their equivalents.

## Claims

1. A module structure, comprising:
a front sheet (11);
a back sheet (19) opposite to the front sheet (11);
an optoelectronic device (15) disposed between the front sheet (11) and the back sheet (19); and
a first encapsulation layer (13) disposed between the optoelectronic device (15) and the front sheet (11),
wherein the back sheet (19) is a layered structure of a hydrogenated styrene elastomer resin layer (19A) and a polyolefin layer (19B), and the hydrogenated styrene elastomer resin layer (19A) is disposed between the optoelectronic device (15) and the polyolefin layer (19B).

2. The module structure as claimed in claim 1, wherein the hydrogenated styrene elastomer resin layer (19A) comprises hydrogenated poly(styrene-b-isoprene), hydrogenated poly(styrene-b-isoprene-b-styrene, hydrogenated poly(styrene-b-butadiene-b-styrene), hydrogenated poly(styrene-b-isoprene/butadiene-b-styrene, or a hydrogenated polystyrene block and a vinyl bonded rich polyisoprene block.

3. The module structure as claimed in claim 1 or 2, wherein the hydrogenated styrene elastomer resin layer (19A) contains about 10wt% to 35wt% of a polystyrene block.

4. The module structure as claimed in one of claims 1 to 3, wherein the hydrogenated styrene elastomer resin layer (19A) has a melt index of about 1.0 g/10min to 8.0 g/10min.

5. The module structure as claimed in one or more of the preceding claims, wherein the first encapsulation layer (13) comprises an ethylene-vinylene acetate copolymer.

6. The module structure as claimed in one or more of the preceding claims, wherein the polyolefin layer (19B) comprises polyethylene, polypropylene, ethylenepropylene copolymer, or a combination thereof.

7. The module structure as claimed in one or more of the preceding claims, wherein the polyolefin layer (19B) is a multi-layered structure.

8. The module structure as claimed in one or more of the preceding claims, wherein the polyolefin layer (19B) has a melt index of about 1.0 g/10min to 8.0 g/10min.

9. The module structure as claimed in one or more of the preceding claims, wherein the hydrogenated styrene elastomer resin layer (19A) has a thickness of 150µm to 300µm.

10. The module structure as claimed in one or more of the preceding claims, wherein the polyolefin layer (19B) has a thickness of 200µm to 500µm.

11. The module structure as claimed in one or more of the preceding claims, wherein the optoelectronic device (15) comprises a solar cell, an organic light emitting diode, or a liquid-crystal display device.

12. The module structure as claimed in one or more of the preceding claims, further comprising a second encapsulation layer (17) disposed between the back sheet (19) and the optoelectronic device (15).

13. The module structure as claimed in claim 12, wherein the second encapsulation layer (17) comprises an ethylene-vinylene acetate copolymer.

14. The module structure as claimed in claim 12 or 13, wherein the hydrogenated styrene elastomer resin layer (19A) has a thickness of 50µm to 150µm.

## Patentansprüche

1. Modulstruktur, umfassend:
ein Vorderseitenflächengebilde (11);
ein Rückseitenflächengebilde (19), gegenüber dem Vorderseitenflächengebilde (11);
eine optoelektronische Vorrichtung (15), die sich zwischen dem Vorderseitenflächengebilde (11) und dem Rückseitenflächengebilde (19) befindet; und
eine erste Einbettungsschicht (13), die sich zwischen der optoelektronischen Vorrichtung (15) und dem Vorderseitenflächengebilde (11) befindet,
wobei das Rückseiten flächengebilde (19) eine Schichtstruktur aus einer hydriertes Styrol-Elastomerharzschicht (19A) und einer Polyolefinschicht (19B) ist und sich die hydriertes Styrol-Elastomerharzschicht (19A) zwischen der optoelektronischen Vorrichtung (15) und der Polyolefinschicht (19B) befindet.

2. Modulstruktur wie in Anspruch 1 beansprucht, wobei die hydriertes Styrol-Elastomerharzschicht (19A) hydriertes Poly(styrol-b-isopren), hydriertes Poly(styrol-b-isopren-b-styrol), hydriertes Poly(styrol-b-butadien-b-styrol), hydriertes Poly(styrol-b-isopren/butadien-b-styrol), oder einen hydriertes Polystyrol-Block und einen Vinylgebundenes reiches Polyisopren-Block umfasst.

3. Modulstruktur wie in Anspruch 1 oder 2 beansprucht, wobei die hydriertes Styrol-Elastomerharzschicht (19A) etwa 10 Gew.-% bis 35 Gew.-% eines Polystyrol-Blocks enthält.

4. Modulstruktur wie in einem der Ansprüche 1 bis 3 beansprucht, wobei die hydriertes Styrol-Elastomerharzschicht (19A) einen Schmelzindex von etwa 1,0 g/10 min bis 8,0 g/10 min aufweist.

5. Modulstruktur wie in einem oder mehr der vorhergehenden Ansprüche beansprucht, wobei die erste Einbettungsschicht (13) Ethylen-Vinylenacetat-Copolymer umfasst.

6. Modulstruktur wie in einem oder mehr der vorhergehenden Ansprüche beansprucht, wobei die Polyolefinschicht (19B) Polyethylen, Polypropylen, Ethylen-Propylen-Copolymer oder eine Kombination davon umfasst.

7. Modulstruktur wie in einem oder mehr der vorhergehenden Ansprüche beansprucht, wobei die Polyolefinschicht (19B) eine Mehrschichtstruktur aufweist.

8. Modulstruktur wie in einem oder mehr der vorhergehenden Ansprüche beansprucht, wobei die Polyolefinschicht (19B) einen Schmelzindex von etwa 1,0 g/10 min bis 8,0 g/10 min aufweist.

9. Modulstruktur wie in einem oder mehr der vorhergehenden Ansprüche beansprucht, wobei die hydriertes Styrol-Elastomerharzschicht (19A) eine Dicke von 150 µm bis 300 µm aufweist.

10. Modulstruktur wie in einem oder mehr der vorhergehenden Ansprüche beansprucht, wobei die Polyolefinschicht (19B) eine Dicke von 200 µm bis 500 µm aufweist.

11. Modulstruktur wie in einem oder mehr der vorhergehenden Ansprüche beansprucht, wobei die optoelektronische Vorrichtung (15) eine Solarzelle, eine organische lichtemittierende Diode oder eine Flüssigkristall-Anzeigevorrichtung umfasst.

12. Modulstruktur wie in einem oder mehr der vorhergehenden Ansprüche beansprucht, ferner umfassend eine zweite Einbettungsschicht (17), die sich zwischen dem Rückseitenflächengebilde (19) und der optoelektronischen Vorrichtung (15) befindet.

13. Modulstruktur wie in Anspruch 12 beansprucht, wobei die zweite Einbettungsschicht (17) ein Ethylen-Vinylenacetat-Copolymer umfasst.

14. Modulstruktur wie in Anspruch 12 oder 13 beansprucht, wobei die hydriertes Styrol-Elastomerharzschicht (19A) eine Dicke von 50 µm bis 150 µm aufweist.

## Revendications

1. Structure de module, comprenant :
une tôle avant (11) ;
une tôle arrière (19) opposée à la tôle avant (11) ;
un dispositif optoélectronique (15) disposé entre la tôle avant (11) et la tôle arrière (19) ; et
une première couche d'encapsulation (13) disposée entre le dispositif optoélectronique (15) et la tôle avant (11),
dans laquelle la tôle arrière (19) est une structure en couche d'une couche de résine élastomère de styrène hydrogéné (19A) et d'une couche de poly(oléfine) (19B), et la couche de résine élastomère de styrène hydrogéné (19A) est disposée entre le dispositif optoélectronique (15) et la couche de poly(oléfine) (19B).

2. Structure de module selon la revendication 1, dans laquelle la couche de résine élastomère de styrène hydrogéné (19A) comprend du poly(styrène-b-isoprène) hydrogéné, du poly(styrène-b-isoprène-b-styrène) hydrogéné, du poly(styrène-b-butadiène-b-styrène) hydrogéné, du poly(styrène-b-isoprène/butadiène-b-styrène) hydrogéné, ou une séquence de poly(styrène) hydrogéné et une séquence de poly(isoprène) riche lié au vinyle.

3. Structure de module selon la revendication 1 ou 2, dans laquelle la couche de résine élastomère de styrène hydrogéné (19A) contient environ 10 % en poids à 35 % en poids d'une séquence de poly(styrène).

4. Structure de module selon l'une des revendications 1 à 3, dans laquelle la couche de résine élastomère de styrène hydrogéné (19A) a un indice de fluidité d'environ 1,0 g/10 min à 8,0 g/10 min.

5. Structure de module selon une ou plusieurs des revendications précédentes, dans laquelle la première couche d'encapsulation (13) comprend un copolymère d'éthylène - acétate de vinylène.

6. Structure de module selon une ou plusieurs des revendications précédentes, dans laquelle la couche de poly(oléfine) (19B) comprend du poly(éthylène), du poly(propylène), un copolymère d'éthylène-propylène ou une combinaison de ceux-ci.

7. Structure de module selon une ou plusieurs des revendications précédentes, dans laquelle la couche de polyoléfine) (19B) est une structure multicouche.

8. Structure de module selon l'une quelconque des revendications précédentes, dans laquelle la couche de poly(oléfine) (19B) a un indice de fluidité d'environ 1,0 g/10 min à 8,0 g/10 min.

9. Structure de module selon une ou plusieurs des revendications précédentes, dans laquelle la couche de résine élastomère de styrène hydrogéné (19A) a une épaisseur de 150 µmà 300 µm.

10. Structure de module selon une ou plusieurs des revendications précédentes, dans laquelle la couche de poly(oléfine) (19B) a une épaisseur de 200 µm à 500 µm.

11. Structure de module selon une ou plusieurs des revendications précédentes, dans laquelle le dispositif optoélectronique (15) comprend une cellule solaire, une diode électroluminescente organique, ou un dispositif d'affichage à cristaux liquides.

12. Structure de module selon une ou plusieurs des revendications précédentes, comprenant en outre une seconde couche d'encapsulation (17) disposée entre la tôle arrière (19) et le dispositif optoélectronique (15).

13. Structure de module selon la revendication 12, dans laquelle la seconde couche d'encapsulation (17) comprend un copolymère d'éthylène - acétate de vinylène.

14. Structure de module selon la revendication 12 ou 13, dans laquelle la couche de résine élastomère de styrène hydrogéné (19A) a une épaisseur de 50 µm à 150 µm.
